(19) Europäisches Patentamt
European Patent Office
Office européen des brevets

(11) **EP 3 440 682 B1**

(12) **EUROPÄISCHE PATENTSCHRIFT**

(45) Veröffentlichungstag und Bekanntmachung des Hinweises auf die Patenterteilung:
**01.03.2023   Patentblatt 2023/09**

(21) Anmeldenummer: **17715733.6**

(22) Anmeldetag: **05.04.2017**

(51) Internationale Patentklassifikation (IPC):
*H01G 4/30* (2006.01)     *H01G 4/38* (2006.01)
*H01G 4/40* (2006.01)     *H01G 2/08* (2006.01)
*H01G 4/008* (2006.01)    *H01G 4/12* (2006.01)

(52) Gemeinsame Patentklassifikation (CPC):
**H01G 4/30; C04B 35/493; C04B 37/006;**
**H01G 4/0085; H01G 4/1218; H01G 4/1245;**
**H01G 4/38; H01G 4/40; H01L 28/55; H01L 28/87;**
C04B 2235/3224; C04B 2235/3225;
C04B 2235/3227; C04B 2235/3229;
C04B 2235/3279;                    (Forts.)

(86) Internationale Anmeldenummer:
**PCT/EP2017/058125**

(87) Internationale Veröffentlichungsnummer:
**WO 2017/174662 (12.10.2017 Gazette 2017/41)**

(54) **MODUL**

MODULE

MODULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.04.2016   DE 102016106284**

(43) Veröffentlichungstag der Anmeldung:
**13.02.2019   Patentblatt 2019/07**

(60) Teilanmeldung:
**22211727.7**

(73) Patentinhaber: **TDK Electronics AG**
**81671 München (DE)**

(72) Erfinder:
• **KOINI, Markus**
**8054 Seiersberg (AT)**
• **KONRAD, Jürgen**
**8042 GRAZ (AT)**
• **KÜGERL, Georg**
**8552 Eibiswald (AT)**

(74) Vertreter: **Epping - Hermann - Fischer Patentanwaltsgesellschaft mbH Schloßschmidstraße 5 80639 München (DE)**

(56) Entgegenhaltungen:
**CN-U- 202 996 592        CN-U- 202 996 592**
**US-A1- 2012 281 335      US-A1- 2012 281 335**

(52) Gemeinsame Patentklassifikation (CPC): (Forts.)
C04B 2235/3281; C04B 2235/3298;
C04B 2235/3418; C04B 2235/768; C04B 2235/79;
C04B 2237/125; C04B 2237/346; C04B 2237/348;
C04B 2237/72; H01G 2/08

**EP 3 440 682 B1**

**Beschreibung**

Die vorliegende Erfindung betrifft ein Modul, das ein Leistungshalbleiterbauelement aufweist.

Die vorliegende Erfindung betrifft insbesondere das Problem der Kühlung von Leistungshalbleiterbauelementen. Um eine hohe Integration und eine hohe Packungsdichte in einem Modul, das ein Leistungshalbleiterbauelement aufweist, zu erreichen, ist ein effektives thermisches Management der Elemente des Moduls notwendig.

Im Stand der Technik sind Leistungshalbleiterbauelemente bekannt, die mit einem Kühlkörper verbunden werden können. Davon räumlich getrennt befindet sich oft ein Zwischenkreis- oder Snubber-Leistungskondensator, welcher im Betrieb des Leistungshalbleiterbauelementes zur Spannungsstabilisierung dient. Das Dokument US2015326221 offenbart ein Modul gemäß dem Oberbegriff des Anspruchs 1.

Aufgabe der vorliegenden Erfindung ist es nunmehr, ein verbessertes Modul anzugeben, das beispielsweise eine hohe Integration und/oder eine hohe Packungsdichte aufweist.

Diese Aufgabe wird durch ein Modul gemäß dem vorliegenden Anspruch 1 gelöst.

Es wird ein Modul vorgeschlagen, das ein Leistungshalbleiterbauelement und einen keramischen Kondensator aufweist, der dazu ausgestaltet ist, das Leistungshalbleiterbauelement zu kühlen.

Dadurch, dass der keramische Kondensator zur Kühlung des Leistungshalbleiterbauelementes verwendet wird, kann auf einen zusätzlichen Kühlkörper verzichtet werden. Auf diese Weise kann die Konstruktion eines kompakteren Moduls ermöglicht werden. Ferner kann auf diese Weise auf eine räumliche Trennung zwischen dem keramischen Kondensator und dem Leistungshalbleiterbauelement verzichtet werden. Dadurch können die Leitungswege zwischen dem keramischen Kondensator und dem Leistungshalbleiterbauelement verkürzt werden. Dieses ist vorteilhaft für die elektrische Funktion des Moduls, da parasitäre Induktivitäten, die durch die Leitungswege zwischen dem Leistungshalbleiterbauelement und dem Kondensator entstehen, wesentlich verringert werden können. Eine Reduzierung der parasitären Induktivitäten ist beispielsweise für Leistungshalbleiterbauelemente, die einen Schalter aufweisen oder eine Schaltung ausbilden, wichtig, um Überspannungen beim Schalten des Leistungshalbleiterbauelementes zu reduzieren.

Als Modul wird hier eine Bauteilanordnung bezeichnet, die zumindest das Leistungshalbleiterbauelement und den keramischen Kondensator aufweist, wobei die Bauteilanordnung als Einheit in einer Schaltungsanordnung verbaut werden kann. Beispielsweise kann die Bauteilanordnung als Einheit auf einer Leiterplatte befestigt werden. Die Elemente des Moduls, d.h. zumindest das Leistungshalbleiterbauelement und der keramischen Kondensator, können in einem gemeinsamen Gehäuse angeordnet sein.

Bei dem Leistungshalbleiterbauelement kann es sich um ein beliebiges Halbleiterbauelement handeln. Insbesondere kann es sich bei dem Leistungshalbleiterbauelement um ein Bauelement handeln, das in der Leistungselektronik für das Steuern und Schalten hoher elektrischer Ströme und Spannungen ausgelegt ist. Es kann sich dabei beispielsweise um eine Leistungsdiode, einen Thyristor, einen Triac oder einen Transistor handeln.

Das Leistungshalbleiterbauelement kann ein Substrat aufweisen, in das Halbleiterelemente eingebettet sind. Das Substrat kann beispielsweise ein Material der Klasse FR-4 aufweisen. Das Substrat kann so ausgefertigt sein, dass es eine hohe elektrische und thermische Leitfähigkeit aufweist und ferner hohe thermomechanische Stressanforderungen erfüllt.

Bei dem keramischen Kondensator kann es sich um ein Vielschichtbauelement handeln, bei dem in einer Stapelrichtung abwechselnd übereinander Schichten eines keramischen Materials und Innenelektroden gestapelt sind. Ferner kann der keramische Kondensator zwei Außenelektroden aufweisen, wobei jede der Innenelektroden mit einer der Außenelektroden verbunden sein kann.

Der keramische Kondensator und das Leistungshalbleiterbauelement sind durch eine zumindest Silber als Bestandteil aufweisende Schicht miteinander verbunden. Die Schicht kann eine gute thermische Leitfähigkeit aufweisen und es auf diese Weise ermöglichen, Hitze von dem Leistungshalbleiterbauelement abzuleiten. Dementsprechend kann die Schicht auf Grund ihrer hohen thermischen Leitfähigkeit den Kondensator in seiner Kühlfunktion unterstützen.

Die Schicht kann Silber als Hauptbestandteil aufweisen. Alternativ kann es sich bei der Schicht um eine silberhaltige Legierung handeln, bei der Silber nicht der Hauptbestandteil ist.

Der keramische Kondensator weist eine Blei-Lanthan-Zirkonat-Titanat (PLZT) Keramik auf. Diese Keramik weist ebenfalls eine hohe thermische Leitfähigkeit auf und kann dadurch zur Kühlfunktion des Kondensators beitragen. Darüber hinaus ist die PLZT Keramik mit Innenelektroden, die aus Kupfer bestehen, kombinierbar. Kupfer eignet sich hier besonders gut als Material für die Innenelektroden des Kondensators, da Kupfer eine hohe thermische Leitfähigkeit aufweist.

Die Schicht, durch die der keramische Kondensator und das Leistungshalbleiterbauelement miteinander verbunden sind, kann zu mindestens 99 Gew.-% aus Silber bestehen. Die Schicht, durch die der keramische Kondensator und das Leistungshalbleiterbauelement miteinander verbunden sind, kann in einem Sinterverfahren gefertigt worden sein.

Der keramische Kondensator kann einen Träger ausbilden, auf dem das Leistungshalbleiterbauelement befestigt ist. Der keramische Kondensator kann als Substrat für das Leistungshalbleiterbauelement dienen.

Dementsprechend kann bei einer Flip-Chip-Montage des Moduls der keramische Kondensator unmittelbar auf einer Leiterplatte befestigt werden, die beispielsweise eine Schaltungsanordnung ausbildet. Das Modul kann auch in einer Oberflächenmontage als sogenanntes SMD-Element (SMD = Surface Mounted Device) auf der Leiterplatte befestigt werden, wobei der keramische Kondensator dabei unmittelbar auf der Leiterplatte befestigt werden kann. Alternativ kann das Modul auch mit der von dem Kondensator wegweisenden Seitenfläche auf einer Leiterplatte in Oberflächenmontage befestigt werden.

Das Modul kann insbesondere frei von einem Träger oder einem Substrat sein, das keine elektrische Funktion übernimmt und lediglich dazu dient, die Elemente des Moduls zu befestigen. Vielmehr kann die Befestigung der Elemente des Moduls miteinander durch die Verwendung des Kondensators als Träger sichergestellt werden, so dass auf einen separaten Träger verzichtet werden kann und eine kompakte, platzsparende Ausgestaltung des Moduls ermöglicht wird.

Der keramische Kondensator und das Leistungshalbleiterbauelement können durch eine Silber-aufweisende Schicht miteinander verbunden sein, die in einem Sinterverfahren gefertigt wurde. Die Schicht kann zu 99 Gew.-% aus Silber bestehen. Der keramische Kondensator kann durch die Schicht sowohl mechanisch mit dem Leistungshalbleiterbauelement verbunden sein als auch elektrisch mit diesem kontaktiert sein.

Die Silber-aufweisende Schicht kann eine hohe thermische Leitfähigkeit aufweisen und dementsprechend mit dazu beitragen, dass von dem Leistungshalbleiterbauelement erzeugte Hitze effektiv über den keramischen Kondensator weggeleitet wird. Ferner kann die Silber-aufweisende Schicht einen thermischen Ausdehnungskoeffizienten aufweisen, der nicht wesentlich von den thermischen Ausdehnungskoeffizienten des Kondensators und des Leistungshalbleiterbauelementes abweicht. Dadurch kann sichergestellt werden, dass bei Temperaturänderungen und damit verbundenen Ausdehnungen der Silber-aufweisenden Schicht, des keramischen Kondensators und des Leistungshalbleiterbauelements innerhalb des Moduls keine signifikanten mechanischen Spannungen entstehen.

Beispielsweise können die thermischen Ausdehnungskoeffizienten des Kondensators, des Leistungshalbleiterbauelementes und der Silber-aufweisenden Schicht um nicht mehr als $10^{-5}$ $K^{-1}$, vorzugsweise um nicht mehr als $10^{-6}$ $K^{-1}$, voneinander abweichen.

Der keramische Kondensator und das Leistungshalbleiterbauelement können durch ein Sintersilberverfahren miteinander verbunden werden. Dabei wird zwischen dem keramischen Kondensator und dem Leistungshalbleiterbauelement eine Paste aufgetragen und diese Anordnung wird einem Sinterprozess unterzogen. Bei dem Sinterprozess wird die Paste zu der Silber-aufweisenden Schicht umgewandelt, die den keramischen Kondensator an dem Leistungshalbleiterbauelement mechanisch befestigt.

Der keramische Kondensator kann ein keramisches Material aufweisen, das in einem elektrischen Feld mit einer Feldstärke zwischen 5 kV/mm und 10 kV/mm eine Dielektrizitätszahl von mehr als 2000 aufweist und das mit Temperaturen von mindestens 150 °C kompatibel ist. Eine elektrische Feldstärke zwischen 5 kV/mm und 10 kV/mm kann der Betriebsfeldstärke des keramischen Kondensators entsprechen. Dementsprechend kann das keramische Material des keramischen Kondensators im Betrieb des Kondensators die Dielektrizitätszahl von mehr als 2000 aufweisen. Die elektrische Feldstärke kann insbesondere 8 kV/mm betragen.

Ein Material wird dabei als "mit einer Temperatur kompatibel" beschrieben, sofern eine Robustheit des Materials bei dieser Temperatur einen vordefinierten Grenzwert nicht unterschreitet. Wird der Grenzwert für die Materialrobustheit unterschritten, so steigt das Risiko eines Bauteilausfalls erheblich an. Demensprechend kann das keramische Material des Kondensators derart gewählt werden, dass der Kondensator auch bei Temperaturen von bis zu 150 °C eine ausreichende Materialrobustheit zeigt, sodass die Ausfallwahrscheinlichkeit des Moduls bei Temperaturen bis 150 °C nicht wesentlich steigt. Diese Eigenschaften des keramischen Materials können dafür sorgen, dass der keramische Kondensator auch dann dazu geeignet ist, das Leistungshalbleiterbauelement zu kühlen, wenn von diesem auf Grund hoher Stromstärken viel Hitze erzeugt wird. Eine Beschädigung des Kondensators durch die Hitze kann so vermieden werden.

Bei dem keramischen Material kann es sich insbesondere um ein mit Lanthanat dotiertes Blei-Zirkonat-Titanat handeln, das beispielsweise die folgende allgemeine Formel erfüllt:

$$Pb_{(1-1,5a+e)}A_aB_b(Zr_{1-x}Ti_x)_{1-c}C_eSi_cO_3 + y \cdot PbO$$

wobei A aus der Gruppe ausgewählt seon kann, die aus La, Nd, Y, Eu, Gd, Tb, Dy, Ho, Er und Yb besteht; C aus der Gruppe ausgewählt sein kann, die aus Ni, und Cu besteht; und

$$0 < a < 0,12$$

$$0,05 \leq x \leq 0,3$$

$$0 \leq c < 0,12$$

$$0,001 < e < 0,12$$

$$0 \leq y < 1$$

erfüllt sein kann.

Dieses Material zeichnet sich dadurch aus, dass es bei hohen Dielektrizitätszahlen von mehr als 2000 mit Temperaturen von bis zu 150 °C kompatibel ist, ohne eine wesentliche Reduzierung seiner Robustheit zu zeigen. Dabei kann das Material diese hohe Dielektrizitätszahl auch dann aufweisen, wenn es einem elektrischen Feld mit einer Feldstärke von 5 kV/mm bis 10 kV/mm ausgesetzt ist. Daher ist es besonders gut zur Kühlung des Leistungshalbleiterbauelements geeignet. Darüber hinaus kann durch dieses Material auf Grund der hohen Dielektrizitätszahl eine hohe Kapazität von dem keramischen Kondensator ausgebildet werden. Eine hohe Kapazität kann die Schalteigenschaften des Leistungshalbleiterbauelements positiv beeinflussen.

Der keramische Kondensator kann ein keramisches Vielschichtbauelement sein und Innenelektroden aufweisen.

Die Innenelektroden können eine thermische Leitfähigkeit von mehr als 100 W/mK aufweisen. Dadurch kann sichergestellt werden, dass von dem Leistungshalbleiterbauelement abgestrahlte Hitze über die Innenelektroden schnell und effektiv abgeleitet werden kann.

Als Material der Innenelektroden kann insbesondere Kupfer gewählt werden. Demensprechend können die Innenelektroden Kupfer aufweisen oder aus Kupfer bestehen.

Das Modul kann zumindest ein weiteres Leistungshalbleiterbauteil aufweisen, wobei der keramische Kondensator dazu ausgestaltet ist, das zumindest eine weitere Leistungshalbleiterbauteil zu kühlen. Der keramische Kondensator kann somit mehrere Leistungshalbleiterbauteile kühlen. Der keramische Kondensator kann ferner als Träger für mehrere Leistungshalbleiterbauteile dienen.

Das Modul kann zumindest einen weiteren Kondensator aufweisen, wobei der weitere Kondensator dazu ausgestaltet ist, das Leistungshalbleiterbauelement zu kühlen. Das Leistungshalbleiterbauelement kann somit von mehreren Kondensatoren gekühlt werden. Mehrere Kondensatoren können in Kombination miteinander einen Träger bilden, auf dem das Leistungshalbleiterbauelement angeordnet ist.

Das Modul kann ferner eine Steuereinheit aufweisen, die dazu ausgestaltet ist, eine Funktion des Leistungshalbleiterbauelementes zu steuern. Das Leistungshalbleiterbauelement kann eine Oberseite, auf der der keramische Kondensator angeordnet ist, und eine Unterseite aufweisen, die der Oberseite gegenüberliegt und auf der die Steuereinheit angeordnet ist. Durch die gegenüberliegende "sandwichartige" Anordnung des keramischen Kondensators und der Steuereinheit mit Bezug auf das Leistungshalbleiterbauelement wird ein besonders kompakter Aufbau des Moduls ermöglicht. Dieser zeichnet sich insbesondere durch kurze Leitungswege und damit verbunden geringe parasitäre Induktivitäten aus.

Das Leistungshalbleiterbauelement kann einen Schalter aufweisen. Beispielsweise kann das Leistungshalbleiterbauelement eine mit Metall beschichtete Keramikschicht aufweisen, die einen Halbleiter-Schalter oder eine Halbleiter-Diode ausbildet.

Der keramische Kondensator kann mit dem Leistungshalbleiterbauelement derart verschaltet sein, dass der keramische Kondensator als Zwischenkreis-Kondensator oder als Dämpfungs-Kondensator wirkt.

Gemäß einem weiteren Aspekt betrifft die vorliegende Erfindung ein Modul, das ein Leistungshalbleiterbauelement und einen keramischen Kondensator, der dazu ausgestaltet ist, das Leistungshalbleiterbauelement zu kühlen, aufweist, wobei der keramische Kondensator eine Blei-Lanthan-Zirkonat-Titanat Keramik aufweist. Diese Keramik zeichnet sich durch eine hohe thermische Leitfähigkeit aus.

Der keramische Kondensator und das Leistungshalbleiterbauelement können durch eine zumindest Silber als Bestandteil aufweisende Schicht miteinander verbunden sein. Die Schicht kann zu mindestens 99 Gew.-% aus Silber besteht.

Der keramische Kondensator kann einen Träger ausbilden, auf dem das Leistungshalbleiterbauelement befestigt ist.

Der keramische Kondensator kann eine keramisches Material gemäß der allgemeinen Formel

$$Pb_{(1-1,5a+e)}A_aB_b(Zr_{1-x}Ti_x)_{1-c}C_eSi_cO_3 + y \cdot PbO$$

aufweisen, wobei A aus der Gruppe ausgewählt ist, die aus La, Nd, Y, Eu, Gd, Tb, Dy, Ho, Er und Yb besteht; C aus der Gruppe ausgewählt ist, die aus Ni, und Cu besteht; und $0 < a < 0,12$, $0,05 \leq x \leq 0,3$, $0 \leq c < 0,12$, $0,001 < e < 0,12$ und $0 \leq y < 1$.

Der keramische Kondensator kann ein keramisches Vielschichtbauelement sein und Innenelektroden aufweisen.

Der keramische Kondensator kann Innenelektroden aufweisen, die eine thermische Leitfähigkeit von mehr als 100 W/mK aufweisen. Die Innenelektroden können Kupfer aufweisen.

Im Folgenden wird ein Satz von vorteilhaften Aspekten genannt. Die Aspekte sind nummeriert, um eine Rückbeziehung der Aspekte aufeinander zu vereinfachen. Merkmale der Aspekte können sowohl für sich genommen als auch in Kombination mit anderen Aspekten von Bedeutung sein.

1. Modul, aufweisend

   ein Leistungshalbleiterbauelement, und
   einen keramischen Kondensator, der dazu ausgestaltet ist, das Leistungshalbleiterbauelement zu kühlen.

2. Modul gemäß dem vorherigen Aspekt,
wobei der keramische Kondensator einen Träger ausbildet, auf dem das Leistungshalbleiterbauelement befestigt ist.

3. Modul gemäß einem der vorherigen Aspekte,
wobei der keramische Kondensator und das Leistungshalbleiterbauelement durch eine Silber-aufweisende Schicht miteinander verbunden sind, die in einem Sinterverfahren gefertigt wurde.

4. Modul gemäß einem der vorherigen Aspekte,
wobei der keramische Kondensator ein keramisches Material aufweist, das in einem elektrischen Feld mit einer Feldstärke zwischen 5 kV/mm und 10 kV/mm eine Dielektrizitätszahl von mehr als 2000 aufweist und das mit Temperaturen von mindestens 150°C kompatibel ist.

5. Modul gemäß einem der vorherigen Aspekte,
wobei der keramische Kondensator eine keramisches Material gemäß der allgemeinen Formel

$$Pb_{(1-1,5a+e)}A_aB_b(Zr_{1-x}Ti_x)_{1-c}C_eSi_cO_3 + y \cdot PbO$$

aufweist, wobei

   A aus der Gruppe ausgewählt ist, die aus La, Nd, Y, Eu, Gd, Tb, Dy, Ho, Er und Yb besteht;
   C aus der Gruppe ausgewählt ist, die aus Ni, und Cu besteht; und

$$0 < a < 0,12$$

$$0,05 \leq x \leq 0,3$$

$$0 \leq c < 0,12$$

$$0,001 < e < 0,12$$

$$0 \leq y < 1.$$

6. Modul gemäß einem der vorherigen Aspekte,
wobei der keramische Kondensator Innenelektroden aufweist, die eine thermische Leitfähigkeit von mehr als 100 W/mK aufweisen.

7. Modul gemäß einem der vorherigen Aspekte,
wobei der keramische Kondensator Innenelektroden aufweist, die Kupfer aufweisen.

8. Modul gemäß einem der vorherigen Aspekte,
wobei das Modul ferner eine Steuereinheit aufweist, die dazu ausgestaltet ist, eine Funktion des Leistungshalbleiterbauelements zu steuern.

9. Modul gemäß dem vorherigen Aspekt,

wobei das Leistungshalbleiterbauelement eine Oberseite aufweist, auf der der keramische Kondensator angeordnet ist, und
wobei das Leistungshalbleiterbauelement eine Unterseite aufweist, die der Oberseite gegenüberliegt und auf der die Steuereinheit angeordnet ist.

10. Modul gemäß einem der vorherigen Aspekte,
wobei das Leistungshalbleiterbauelement einen Schalter aufweist.

11. Modul gemäß einem der vorherigen Aspekte,
wobei der keramische Kondensator mit dem Leistungshalbleiterbauelement derart verschaltet ist, dass der keramische Kondensator als Zwischenkreis-Kondensator oder als Dämpfungs-Kondensator wirkt.

Im Folgenden wird die vorliegende Erfindung anhand der Figuren näher beschrieben.

Figur 1    zeigt ein Modul gemäß einem ersten Ausführungsbeispiel,

Figur 2    zeigt ein Modul gemäß einem zweiten Ausführungsbeispiel.

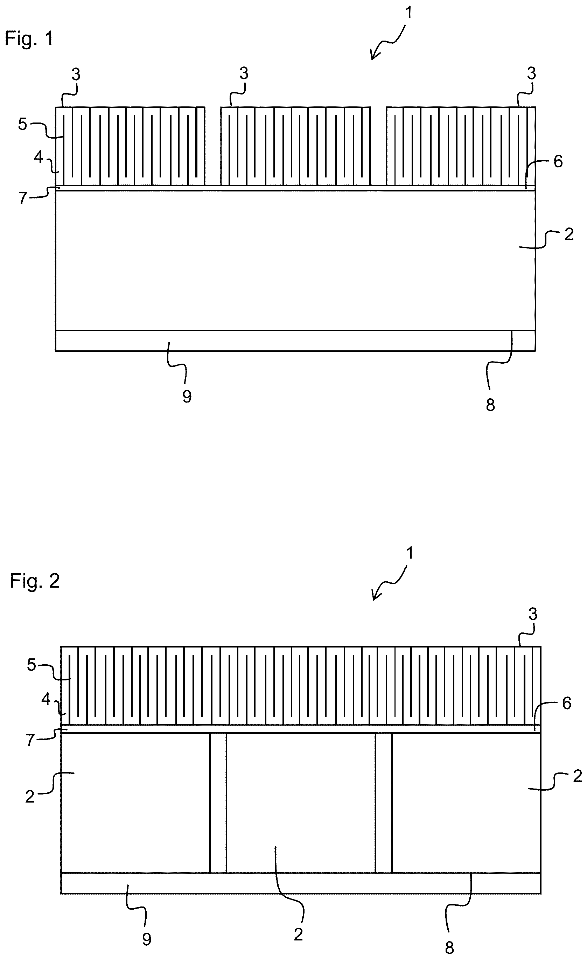

Figur 1 zeigt ein erstes Ausführungsbeispiel eines Moduls 1. Das Modul 1 weist ein Leistungshalbleiterbauelement 2 auf. Das Leistungshalbleiterbauelement 2 kann beispielsweise zu einer Schaltung ausgestaltet sein, die eine Schaltfunktion übernimmt. Dementsprechend kann das Leistungshalbleiterbauelement 2 einen Schalter aufweisen. Das Leistungshalbleiterbauelement 2 kann ein Substrat aufweisen, in das Halbleiterelemente integriert sind.
Das Modul 1 weist ferner einen keramischen Kondensator 3 auf. Der keramische Kondensator 3 übernimmt eine Doppelfunktion. Der keramische Kondensator 3 stellt eine Kapazität dar, die mit einer von dem Leistungshalbleiterbauelement 2 ausgebildeten Schaltung verbunden ist. Dabei kann der keramische Kondensator 3 beispielsweise ein Zwischenkreis-kondensator oder ein Snubberkondensator sein. Bei einem Snubberkondensator handelt es sich um eine dämpfend wirkende Kapazität, die der Spannungsstabilisierung dient und Spannungsspitzen vermeiden soll.
Darüber hinaus übernimmt der keramische Kondensator 3 die Funktionalität eines Kühlkörpers. Insbesondere kühlt der keramische Kondensator 3 das Leistungshalbleiterbauelement 2 im Betrieb. Die Materialien des keramischen Kondensators 3 sind so gewählt, dass der keramische Kondensator 3 zum einen dazu geeignet ist, von dem Leistungsbauelement 2 erzeugte Hitze von diesem wegzuleiten und zum anderen durch die Hitze nicht beschädigt wird.
Der keramische Kondensator 3 weist ein keramisches Material 4 und Innenelektroden 5 auf. Bei dem keramischen Material 4 kann es sich um mit Lanthanat dotiertes Blei-Zirkonat-Titanat (PLZT) handeln. Dieses Material 4 weist eine hohe Dielektrizitätszahl auf, wodurch eine hohe Kapazität des Kondensators 3 ermöglicht wird, und ist hitzebeständig, so dass es durch die von dem Leistungshalbleiterbauelement 2 abgestrahlte Hitze nicht beschädigt wird.
Die Innenelektroden 5 und das keramische Material 4 sind in dem keramischen Kondensator 3 in einer Stapelrichtung abwechselnd übereinander gestapelt. Die Stapelrichtung ist parallel zu einer Oberseite 6 des Leistungshalbleiterbauelementes 2. Dementsprechend stehen die Innenelektroden 5 senkrecht auf der Oberseite 6.
Die Innenelektroden 5 können Kupfer aufweisen oder aus Kupfer bestehen. Wird Kupfer als Material der Innenelektroden 5 gewählt, so lassen sich auf diese Weise Innenelektroden 5 mit einer hohen Wärmeleitfähigkeit erzeugen. Aufgrund der hohen Wärmeleitfähigkeit der Innenelektroden 5 sind diese dazu geeignet, von dem Leistungshalbleiterbauelement 2 abgestrahlte Hitze schnell und effektiv von diesem wegzuleiten.
Die Hitze kann dabei von der Oberseite 6 des Leistungshalbleiterbauelements 2 an den keramischen Kondensator 3 abgegeben werden. Dann kann die Hitze über die Innenelektroden 5 zu einer Oberseite des keramischen Kondensators 3, die von dem Leistungshalbleiterbauelement 2 weg weist, geleitet werden. Von der Oberseite des keramischen Kondensators 3 wird die Hitze nunmehr an eine Umgebung des Moduls 1 abgestrahlt. Auf diese Weise wird die Hitze von dem Leistungshalbleiterbauelement 2 weggeleitet, so dass eine Überhitzung des Leistungshalbleiterbauelements 2 verhindert wird.
Ferner weist der Kondensator 3 zwei Außenelektroden auf, die zur Vereinfachung der Darstellung in der Figur 1 nicht eingezeichnet sind. Die Außenelektroden können ebenfalls Kupfer aufweisen oder aus Kupfer bestehen. Die Außenelektroden können daher die vom Leistungshalbleiterbauelement 2 erzeugte Hitze effektiv weiterleiten.
In einem alternativen, nicht gezeigten, Ausführungsbeispiel sind die Innenelektroden 5 parallel zu der Oberseite 6 des Leistungshalbleiterbauelementes 2 angeordnet. In diesem Fall kann der keramische Kondensator 3 eine Verbindungsvorrichtung, beispielsweise einen Rahmen aus Kupfer, aufweisen. Die Innenelektroden 5 können über die Verbindungsvorrichtung mit dem Leistungshalbleiterbauelement 2 kontaktiert werden.

In diesem Fall wird Hitze, die von dem Leistungshalbleiterbauelement 2 abgestrahlt wird, von der Verbindungsvorrichtung aufgenommen und an die Innenelektroden 5 weitergeleitet. Diese können wiederum die Hitze von dem Leistungshalbleiterbauelement 2 wegleiten und letztlich dafür sorgen, dass die Hitze an eine Umgebung abgegeben werden kann.

Der keramische Kondensator 3 ist auf dem Leistungshalbleiterbauelement 2 durch eine Silber-aufweisende Schicht 7 befestigt und wird durch diese Schicht 7 auch mit dem Leistungshalbleiterbauelement 2 elektrisch kontaktiert. Die Silber-aufweisende Schicht 7 wird in einem Sinterverfahren gefertigt. Diese Schicht 7 zeichnet sich durch eine besonders hohe thermische Leitfähigkeit aus.

Auf einer Unterseite 8 des Leistungshalbleiterbauelementes 2, die der Oberseite 6 gegenüberliegt, ist eine Steuereinheit 9 angeordnet. Die Steuereinheit 9 ist mit dem Leistungshalbleiterbauelement 2 verschaltet. Die Steuereinheit 9 ist insbesondere dazu ausgestaltet, eine Funktion des Leistungshalbleiterbauelementes 2 zu steuern.

Durch die in Figur 1 gezeigte Anordnung des keramischen Kondensators 3, des Leistungshalbleiterbauelementes 2 und der Steuereinheit 9 in unmittelbarer Nähe zueinander kann sichergestellt werden, dass das Modul 1 einen sehr kompakten Aufbau aufweist und insbesondere kurze Leiterwege zwischen dem Kondensator 3 und dem Leistungshalbleiterbauelement 2 sowie zwischen der Steuereinheit 9 und dem Leistungshalbleiterbauelement 2 ermöglicht werden. Aufgrund der kurzen Leiterwege können parasitäre Induktivitäten in diesem Modulaufbau minimiert werden.

Bei dem in Figur 1 gezeigten Ausführungsbeispiel sind auf einem einzigen Leistungshalbleiterbauelement 2 mehrere Kondensatoren 3 angeordnet, wobei jeder dieser Kondensatoren 3 die Funktion eines Kühlkörpers übernimmt und dementsprechend dazu ausgestaltet ist, das Leistungshalbleiterbauelement 2 zu kühlen.

Figur 2 zeigt ein zweites Ausführungsbeispiel des Moduls 1. Das zweite Ausführungsbeispiel weist einen einzigen keramischen Kondensator 3 auf, der dazu geeignet ist, eines oder mehrere der Leistungshalbleiterbauelemente 2 zu kühlen. Auf dem keramischen Kondensator 3 sind mehrere Leistungshalbleiterbauelemente 2 angeordnet. Dabei sind diese wiederum durch eine Silber-aufweisende Schicht 7 mit dem Kondensator 3 verbunden. Der keramische Kondensator 3 dient hierbei als Substrat oder Träger für die Leistungshalbleiterbauelemente 2.

Das Modul 1 ist dazu geeignet, in einer Oberflächenmontage auf einer Leiterplatte befestigt zu werden. Dabei wird der keramische Kondensator 3 mit seiner von dem Leistungshalbleiterbauelement 2 wegweisenden Seite auf der Leiterplatte befestigt. Alternativ kann die Steuereinheit 9 mit ihrer von dem Leistungshalbleiterbauelement 2 wegweisenden Seite auf der Leiterplatte befestigt werden.

Bezugszeichenliste

1   Modul
2   Leistungshalbleiterbauelement
3   Kondensator
4   keramisches Material
5   Innenelektrode
6   Oberseite
7   Silber-aufweisende Schicht
8   Unterseite
9   Steuereinheit

**Patentansprüche**

1. Modul (1), aufweisend
   ein Leistungshalbleiterbauelement (2), und einen keramischen Kondensator (3), **dadurch gekennzeichnet, dass** der Kondensator dazu ausgestaltet ist, das Leistungshalbleiterbauelement (2) zu kühlen, wobei der keramische Kondensator (3) eine Blei-Lanthan-Zirkonat-Titanat Keramik aufweist.

2. Modul (1) gemäß Anspruch 1,
   wobei der keramische Kondensator (3) und das Leistungshalbleiterbauelement (2) durch eine zumindest Silber als Bestandteil aufweisende Schicht (7) miteinander verbunden sind.

**3.** Modul (1) gemäß Anspruch 2,
wobei die Schicht (7), durch die der keramische Kondensator (3) und das Leistungshalbleiterbauelement (2) miteinander verbunden sind, zu mindestens 99 Gew.-% aus Silber besteht.

**4.** Modul (1) gemäß Anspruch 2 oder Anspruch 3,
wobei die Schicht (7), durch die der keramische Kondensator (3) und das Leistungshalbleiterbauelement (2) miteinander verbunden sind, in einem Sinterverfahren gefertigt wurde.

**5.** Modul (1) gemäß einem der vorherigen Ansprüche,
wobei der keramische Kondensator (3) einen Träger ausbildet, auf dem das Leistungshalbleiterbauelement (2) befestigt ist.

**6.** Modul (1) gemäß einem der vorherigen Ansprüche,
wobei der keramische Kondensator (3) ein keramisches Material aufweist, das in einem elektrischen Feld mit einer Feldstärke zwischen 5 kV/mm und 10 kV/mm eine Dielektrizitätszahl von mehr als 2000 aufweist und das mit Temperaturen von mindestens 150°C kompatibel ist.

**7.** Modul (1) gemäß einem der vorherigen Ansprüche, wobei der keramische Kondensator (3) eine keramisches Material gemäß der allgemeinen Formel

$$Pb_{(1-1,5a+e)}A_aB_b(Zr_{1-x}Ti_x)_{1-c}C_eSi_cO_3 + y \cdot PbO$$

aufweist, wobei

A aus der Gruppe ausgewählt ist, die aus La, Nd, Y, Eu, Gd, Tb, Dy, Ho, Er und Yb besteht;
C aus der Gruppe ausgewählt ist, die aus Ni, und Cu besteht; und

$$0 < a < 0,12$$

$$0,05 \leq x \leq 0,3$$

$$0 \leq c < 0,12$$

$$0,001 < e < 0,12$$

$$0 \leq y < 1.$$

**8.** Modul (1) gemäß einem der vorherigen Ansprüche,
wobei der keramische Kondensator (3) ein keramisches Vielschichtbauelement ist und Innenelektroden (5) aufweist.

**9.** Modul (1) gemäß dem vorherigen Anspruch,
wobei die Innenelektroden eine thermische Leitfähigkeit von mehr als 100 W/mK aufweisen.

**10.** Modul (1) gemäß einem der Ansprüche 8 oder 9,
wobei die Innenelektroden Kupfer aufweisen.

**11.** Modul (1) gemäß einem der vorherigen Ansprüche, aufweisend zumindest ein weiteres Leistungshalbleiterbauteil,
wobei der keramische Kondensator (3) dazu ausgestaltet ist, das zumindest eine weitere Leistungshalbleiterbauteil (2) zu kühlen.

**12.** Modul (1) gemäß einem der vorherigen Ansprüche, aufweisend zumindest einen weiteren Kondensator, wobei der weitere Kondensator dazu ausgestaltet ist, das Leistungshalbleiterbauelement (2) zu kühlen.

**13.** Modul (1) gemäß einem der vorherigen Ansprüche,
wobei das Modul (1) ferner eine Steuereinheit (9) aufweist, die dazu ausgestaltet ist, eine Funktion des Leistungshalbleiterbauelements (2) zu steuern.

**14.** Modul (1) gemäß dem vorherigen Anspruch,

wobei das Leistungshalbleiterbauelement (2) eine Oberseite (6) aufweist, auf der der keramische Kondensator (3) angeordnet ist, und
wobei das Leistungshalbleiterbauelement (2) eine Unterseite (8) aufweist, die der Oberseite (6) gegenüberliegt und auf der die Steuereinheit (9) angeordnet ist.

**15.** Modul (1) gemäß einem der vorherigen Ansprüche,
wobei das Leistungshalbleiterbauelement (2) einen Schalter aufweist.

**16.** Modul (1) gemäß einem der vorherigen Ansprüche,
wobei der keramische Kondensator (3) mit dem Leistungshalbleiterbauelement (2) derart verschaltet ist, dass der keramische Kondensator (3) als Zwischenkreis-Kondensator oder als Dämpfungs-Kondensator wirkt.

**17.** Modul (1) gemäß einem der vorherigen Ansprüche,
wobei das Leistungshalbleiterbauelement (2) und der keramischen Kondensator (3) als Einheit in einer Schaltungsanordnung verbaut sind, die auf einer Leiterplatte befestigt ist.

**18.** Modul (1) gemäß einem der vorherigen Ansprüche,
wobei das Leistungshalbleiterbauelement (2) und der keramischen Kondensator (3) in einem gemeinsamen Gehäuse angeordnet sind.

**19.** Modul (1) gemäß einem der vorherigen Ansprüche,
wobei das Leistungshalbleiterbauelement (2) ein Substrat aufweist, in das Halbleiterelemente eingebettet sind.

**20.** Modul (1) gemäß einem der vorherigen Ansprüche,
wobei der Kondensator (3) zwei Außenelektroden aufweist.

**21.** Modul (1) gemäß dem vorherigen Anspruch,
wobei die Außenelektroden Kupfer aufweisen.

**Claims**

**1.** Module (1), comprising a power semiconductor component (2) and a ceramic capacitor (3), **characterized in that** the capacitor is configured for cooling the power semiconductor component (2), wherein the ceramic capacitor (3) comprises a lead-lanthanum-zirconate-titanate ceramic.

**2.** Module (1) according to Claim 1, wherein the ceramic capacitor (3) and the power semiconductor component (2) are connected by a layer (7) at least comprising silver as a constituent.

**3.** Module (1) according to Claim 2, wherein the layer (7) by which the ceramic capacitor (3) and the power semiconductor component (2) are connected consists of silver to an extent of at least 99% by weight.

**4.** Module (1) according to Claim 2 or Claim 3, wherein the layer (7) by which the ceramic capacitor (3) and the power semiconductor component (2) are connected has been manufactured in a sintering process.

**5.** Module (1) according to any of the preceding claims, wherein the ceramic capacitor (3) forms a carrier on which the power semiconductor component (2) is secured.

**6.** Module (1) according to any of the preceding claims, wherein the ceramic capacitor (3) comprises a ceramic material which in an electric field having a field strength between 5 kV/mm and 10 kV/mm has a relative permittivity of more than 2000 and which is compatible with temperatures of at least 150°C.

7. Module (1) according to any of the preceding claims, wherein the ceramic capacitor (3) comprises a ceramic material according to general formula

$$Pb_{(1-1,5a+e)}A_aB_b(Zr_{1-x}Ti_x)_{1-c}C_eSi_cO_3 + y.PbO,$$

wherein

A is selected from the group consisting of La, Nd, Y, Eu, Gd, Tb, Dy, Ho, Er and Yb;
C is selected from the group consisting of Ni and Cu; and

$$0 < a < 0.12$$

$$0.05 \leq x \leq 0.3$$

$$0 \leq c < 0.12$$

$$0.001 < e < 0.12$$

$$0 \leq y < 1.$$

8. Module (1) according any of the preceding claims, wherein the ceramic capacitor (3) is a ceramic multilayer component and comprises inner electrodes (5) .

9. Module (1) according to the preceding claim, wherein the inner electrodes have a thermal conductivity of more than 100 W/mK.

10. Module (1) according to either of Claims 8 or 9, wherein the inner electrodes comprise copper.

11. Module (1) according to any of the preceding claims, comprising at least one further power semiconductor component, wherein the ceramic capacitor (3) is configured for cooling the at least one further power semiconductor component (2).

12. Module (1) according to any of the preceding claims, comprising at least one further capacitor, wherein the further capacitor is configured for cooling the power semiconductor component (2).

13. Module (1) according to any of the preceding claims, wherein the module (1) further comprises a control unit (9) configured for controlling a function of the power semiconductor component (2).

14. Module (1) according to the preceding claim, wherein the power semiconductor component (2) has a top surface (6) on which the ceramic capacitor (3) is arranged and wherein the power semiconductor component (2) has a bottom surface (8) which is opposite the top surface (6) and on which the control unit (9) is arranged.

15. Module (1) according to any of the preceding claims, wherein the power semiconductor component (2) comprises a switch.

16. Module (1) according to any of the preceding claims, wherein the ceramic capacitor (3) is connected to the power semiconductor component (2) such that the ceramic capacitor (3) functions as a link capacitor or as a damping capacitor.

17. Module (1) according to any of the preceding claims, wherein the power semiconductor component (2) and the ceramic capacitor (3) are installed as a unit in a switching assembly secured to a circuit board.

18. Module (1) according to any of the preceding claims, wherein the power semiconductor component (2) and the ceramic capacitor (3) are arranged in a common housing.

19. Module (1) according to any of the preceding claims, wherein the power semiconductor component (2) comprises a substrate in which semiconductor elements are embedded.

20. Module (1) according to any of the preceding claims, wherein the capacitor (3) comprises two outer electrodes.

21. Module (1) according to the preceding claim, wherein the outer electrodes comprise copper.

**Revendications**

1. Module (1), présentant

   un composant semi-conducteur de puissance (2), et
   un condensateur céramique (3),
   **caractérisé en ce que** le condensateur est configuré pour refroidir le composant semi-conducteur de puissance (2), le condensateur céramique (3) présentant une céramique à base de plomb, lanthane, zirconate, titanate.

2. Module (1) selon la revendication 1, dans lequel le condensateur céramique (3) et le composant semi-conducteur de puissance (2) sont reliés l'un à l'autre par une couche (7) présentant comme composant au moins de l'argent.

3. Module (1) selon la revendication 2, dans lequel la couche (7) par laquelle le condensateur céramique (3) et le composant semi-conducteur de puissance (2) sont reliés l'un à l'autre est composée d'au moins 99 % en poids d'argent.

4. Module (1) selon la revendication 2 ou la revendication 3, dans lequel la couche (7) par laquelle le condensateur céramique (3) et le composant semi-conducteur de puissance (2) sont reliés l'un à l'autre a été fabriquée selon un procédé de frittage.

5. Module (1) selon l'une quelconque des revendications précédentes, dans lequel le condensateur céramique (3) réalise un support sur lequel est fixé le composant semi-conducteur de puissance (2).

6. Module (1) selon l'une quelconque des revendications précédentes, dans lequel le condensateur céramique (3) présente un matériau céramique qui présente dans un champ électrique d'une intensité de champ comprise entre 5 kV/mm et 10 kV/mm une constante diélectrique de plus de 2000 et qui est compatible avec des températures d'au moins 150 °C.

7. Module (1) selon l'une quelconque des revendications précédentes, dans lequel le condensateur céramique (3) présente un matériau céramique selon la formule générale

$$Pb_{(1-1,5a+e)}A_aB_b(Zr_{1-x}Ti_x)_{1-c}C_eSi_cO_3 + y \cdot Pb0$$

où

A est sélectionné dans le groupe composé de La, Nd, Y, Eu, Gd, Tb, Dy, Ho, Er et Yb ;
C est sélectionné dans le groupe composé de Ni et Cu ; et

$$0 < a < 0,12$$

$$0,05 \leq x \leq 0,3$$

$$0 \leq c < 0,12$$

$$0,001 < e < 0,12$$

$$0 \leq y < 1.$$

8. Module (1) selon l'une quelconque des revendications précédentes, dans lequel le condensateur céramique (3) est un composant multicouche céramique et présente des électrodes intérieures (5).

9. Module (1) selon la revendication précédente, dans lequel les électrodes intérieures présentent une conductibilité thermique de plus de 100 W/mK.

10. Module (1) selon l'une quelconque des revendications 8 ou 9, dans lequel les électrodes intérieures présentent du cuivre.

11. Module (1) selon l'une quelconque des revendications précédentes, présentant au moins un autre composant semi-conducteur de puissance, dans lequel le condensateur céramique (3) est configuré pour refroidir ledit au moins un autre composant semi-conducteur de puissance (2).

12. Module (1) selon l'une quelconque des revendications précédentes, présentant au moins un autre condensateur, dans lequel l'autre condensateur est configuré pour refroidir le composant semi-conducteur de puissance (2).

13. Module (1) selon l'une quelconque des revendications précédentes, dans lequel le module (1) présente en outre une unité de commande (9) qui est configurée pour commander une fonction du composant semi-conducteur de puissance (2).

14. Module (1) selon la revendication précédente, dans lequel le composant semi-conducteur de puissance (2) présente une face supérieure (6) sur laquelle est disposé le condensateur céramique (3), et dans lequel le composant semi-conducteur de puissance (2) présente une face inférieure (8) qui est opposée à la face supérieure (6) et sur laquelle est disposée l'unité de commande (9).

15. Module (1) selon l'une quelconque des revendications précédentes, dans lequel le composant semi-conducteur de puissance (2) présente un commutateur.

16. Module (1) selon l'une quelconque des revendications précédentes, dans lequel le condensateur céramique (3) est câblé avec le composant semi-conducteur de puissance (2) de telle sorte que le condensateur céramique (3) agit comme un condensateur de circuit intermédiaire ou un condensateur amortisseur.

17. Module (1) selon l'une quelconque des revendications précédentes, dans lequel le composant semi-conducteur de puissance (2) et le condensateur céramique (3) sont installés sous la forme d'une unité dans un agencement de circuit qui est fixé sur une carte de circuits imprimés.

18. Module (1) selon l'une quelconque des revendications précédentes, dans lequel le composant semi-conducteur de puissance (2) et le condensateur céramique (3) sont disposés dans un boîtier commun.

19. Module (1) selon l'une quelconque des revendications précédentes, dans lequel le composant semi-conducteur de puissance (2) présente un substrat dans lequel des éléments semi-conducteurs sont incorporés.

20. Module (1) selon l'une quelconque des revendications précédentes, dans lequel le condensateur (3) présente deux électrodes extérieures.

21. Module (1) selon la revendication précédente, dans lequel les électrodes extérieures présentent du cuivre.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2015326221 A